# FASCICULE DE BREVET EUROPEEN

(11) **EP 4 414 715 B1**
(45) Date de publication et mention de la délivrance du brevet: **14.10.2026**
(21) Numéro de dépôt: 24157127.2
(22) Date de dépôt: 12.02.2024
(51) Int. Cl.: G01R 15/14

(54) **DISPOSITIF DE MESURE DE GRANDEURS ÉLECTRIQUES DANS UNE INSTALLATION ÉLECTRIQUE ET SYSTÈME ASSOCIÉ**
VORRICHTUNG ZUR MESSUNG ELEKTRISCHER GRÖSSEN IN EINER ELEKTRISCHEN ANLAGE UND SYSTEM DAFÜR
DEVICE FOR MEASURING ELECTRICAL QUANTITIES IN AN ELECTRICAL INSTALLATION AND ASSOCIATED SYSTEM

(30) Priorité: 13.02.2023 FR 2301315
(43) Date de publication de la demande: 14.08.2024
(73) Titulaire: SCHNEIDER ELECTRIC INDUSTRIES SAS, 92500 Rueil-Malmaison (FR)
(72) Inventeur: SICARD, Stéphane, 38350 La Mure (FR); CAILLOU, Jonathan, 38500 La Buisse (FR); ALVES, Brandon, 38400 Saint-Martin-d'Hères (FR); KOCH, Juliette, 38100 Grenoble (FR); WOLOZAN, Stéphane, 38130 Échirolles (FR); RONDOT, Loïc, 38240 Meylan (FR)
(74) Mandataire: Lavoix

(56) Documents cités:
- GB-A- 2 548 863
- US-A1- 2012 200 291
- US-A1- 2014 209 352
- US-A1- 2015 002 138

## Description

La présente invention concerne un dispositif de mesure de grandeurs électriques dans une installation électrique, intégré dans un boîtier comprenant au moins un bloc unitaire, le bloc unitaire comportant un logement traversant adapté pour recevoir un conducteur électrique de ladite installation électrique.

L'invention se situe dans le domaine de la mesure et du calcul de grandeurs électriques, de manière distribuée, dans une installation électrique.

En effet, dans des installations électriques, par exemple des réseaux locaux de distribution d'électricité, il est utile de mesurer des grandeurs électriques, en particulier le courant électrique, la tension, sur divers conducteurs électriques, dans plusieurs localisations du réseau, et de calculer d'autres grandeurs électriques, e.g. la puissance, l'énergie etc.

Les documents GB 2 548 863 A, US 2015/002138 A1 et US 2012/200291 A1 décrivent des systèmes de mesure de grandeurs électriques.

On connaît par exemple des dispositifs de mesure de grandeurs électriques, e.g. capteurs de courant ou de tension, qui ont des capacités de communication des grandeurs électriques mesurées, ce qui permet mettre en œuvre un réseau de communication entre des dispositifs de mesure vers un dispositif de communication passerelle, ce qui facilite la supervision et le contrôle du réseau électrique par des utilisateurs.

De plus, un calcul d'autres grandeurs électriques à partir des valeurs de courant et de tension mesurées par de tels capteurs peut être avantageusement réalisé dans un tel réseau de communication distribué.

Cependant, l'installation et la maintenance de tels dispositifs capteurs de courant et de tension dans une installation électrique, notamment pour une installation électrique comportant une pluralité de charges et de sources, connectées en plusieurs étages de connexion, par une pluralité de conducteurs électriques, peut s'avérer coûteuse, en temps et en main d'œuvre, du fait de la nécessité d'installer un nombre important de capteurs, et d'effectuer des opérations débranchement des conducteurs électriques de l'installation.

Il existe donc un besoin de faciliter la manipulation, d'installation et de maintenance, de dispositifs de mesure de grandeurs électriques.

A cet effet, l'invention propose, selon un aspect, un dispositif de mesure de grandeurs électriques dans une installation électrique, intégré dans un boîtier comprenant au moins un bloc unitaire, le bloc unitaire comportant un logement traversant adapté pour recevoir un conducteur électrique de ladite installation électrique, le logement traversant s'étendant selon un axe principal. Le ou chaque bloc unitaire comprend :
- un module de mesure de courant, configuré pour mesurer un courant électrique circulant dans ledit conducteur électrique,
- un module de mesure de tension par couplage capacitif,
- un module d'alimentation électrique, configuré pour capter une énergie électrique à partir dudit conducteur électrique,
   lesdits modules étant agencés autour dudit logement traversant destiné à recevoir le conducteur électrique,
   le module de mesure de courant et le module d'alimentation électrique étant empilés dans le sens défini par l'axe principal, le module de mesure de courant comportant une première partie creuse et le module d'alimentation électrique comportant une deuxième partie creuse, lesdites première et deuxième parties creuses étant centrées autour de l'axe principal et formant le logement traversant,
   le bloc unitaire comportant en outre dispositif électronique, comportant une interface de communication sans fil adaptée à communiquer selon un protocole de communication sans fil prédéterminé et un circuit électronique programmable,
   le dispositif électronique étant alimenté en énergie électrique par ledit module d'alimentation électrique, le circuit électronique programmable étant configuré pour recevoir, de manière continue, des mesures de courant et de tension desdits modules de mesure de courant et de tension, et pour commander la transmission par ladite interface de communication d'au moins une grandeur électrique associée au signal électrique circulant dans le conducteur électrique reçu dans le logement traversant, obtenue à partir desdites mesures de courant et de tension.

Avantageusement, le dispositif de mesure proposé fournit à la fois une mesure de courant grâce à la présence du module de mesure de courant et une mesure de tension grâce à la présence du dispositif de mesure de tension.

Avantageusement, le dispositif de mesure de grandeurs électriques proposé et du type auto-alimenté en énergie électrique grâce à la présence du module d'alimentation. Ainsi, aucune alimentation électrique auxiliaire n'est nécessaire, ni aucun câble dédié à cet effet.

Avantageusement, le dispositif de mesure de grandeurs électriques proposé intègre une interface de communication sans fil et un circuit électronique programmable. Ainsi, le dispositif de mesure de grandeurs électriques proposé est autonome pour une pluralité de fonctionnalités.

Le dispositif de mesure de grandeurs électriques selon l'invention peut présenter une ou plusieurs des caractéristiques ci-dessous, prises indépendamment ou selon toutes les combinaisons acceptables.

La grandeur électrique est un courant, une tension, une puissance active ou réactive, une énergie électrique, une fréquence, un facteur de puissance, une distorsion harmonique du signal électrique.

Le ou chaque bloc unitaire est agencé en une première portion et une deuxième portion assemblées, lesdites première et deuxième portion étant au moins partiellement séparables l'une de l'autre, de manière à permettre une ouverture et une fermeture dudit bloc unitaire, lesdites première et deuxième portions coopérant pour former le logement traversant.

Les première et deuxième portions sont liées par au moins un pivot à deux axes de rotation.

Le module de mesure de tension comporte un capteur s'étendant dans le logement traversant selon la direction de l'axe principal et un support connecté audit capteur et au dispositif électronique, formant un capteur de tension par couplage capacitif avec le conducteur électrique.

Le module de mesure de courant comporte un capteur de courant, le capteur de courant comportant un enroulement principal de fil conducteur, et un élément ferromagnétique de forme incurvée, comportant une portion centrale arrondie et deux bras de même longueur s'étendant de part et d'autre de la portion centrale arrondie, l'élément ferromagnétique ayant un axe de symétrie parallèle à chacun des bras, l'enroulement principal s'étendant selon une direction perpendiculaire audit axe de symétrie, et étant disposé entre lesdits bras de l'élément ferromagnétique.

Le capteur de courant est configuré pour s'ouvrir en deux parties, une première partie comportant au moins l'enroulement principal et lesdits bras, et une deuxième partie comportant la portion centrale arrondie.

L'enroulement principal a une première extrémité et une deuxième extrémité, lesdits bras de l'élément ferromagnétique étant respectivement un premier bras et un deuxième bras, le capteur comportant en outre des enroulements de compensation, disposés de part et d'autre de l'enroulement principal, respectivement entre la première extrémité de l'enroulement principal et le premier bras et entre la deuxième extrémité de l'enroulement principal et le deuxième bras.

Le module d'alimentation électrique comporte un bloc de transformation de courant comportant un transformateur magnétique de courant ayant une inductance magnétisante équivalente, un bloc de conversion alternatif/continu comportant un condensateur dit de compensation, configuré pour compenser une perte d'énergie due au transformateur magnétique de courant, et un bloc de stockage d'énergie électrique.

Le module d'alimentation électrique comporte en outre un bloc d'adaptation d'impédance connecté entre le bloc de conversion et le bloc de stockage d'énergie.

Le bloc de conversion est bloc multiplicateur de tension comportant le condensateur compensation et une diode anti-retour connectée en sortie du condensateur de compensation, le condensateur de compensation ayant une capacité choisie pour compenser l'inductance magnétisante équivalente du transformateur magnétique de courant.

Selon un autre aspect, l'invention concerne un système de calcul de grandeurs électriques dans une installation électrique, comportant une pluralité de dispositifs de mesure de grandeurs électriques tels que brièvement décrits ci-dessus et un dispositif de communication passerelle, configurés pour communiquer selon un protocole de communication sans fil choisi.

D'autres caractéristiques et avantages de l'invention ressortiront de la description qui en est donnée ci-dessous, à titre indicatif et nullement limitatif, en référence aux figures annexées, parmi lesquelles :
[Fig 1] la figure 1 représente schématiquement un système de calcul de grandeurs électriques distribué dans une installation électrique ;
[Fig 2] la figure 2 est une vue en perspective d'un dispositif de mesure de grandeurs électriques selon un mode de réalisation ;
[Fig 3] la figure 3 est une vue en perspective d'un bloc unitaire d'un dispositif de mesure de grandeurs électriques dans une position fermée ;
[Fig 4] la figure 4 est une vue en perspective d'un bloc unitaire d'un dispositif de mesure de grandeurs électriques dans une position ouverte ;
[Fig 5] la figure 5 est une première vue en perspective d'un dispositif de mesure de grandeurs électriques, sans boîtier, selon un mode de réalisation ;
[Fig 6] la figure 6 est une deuxième vue en perspective d'un dispositif de mesure de grandeurs électriques, sans boîtier, selon un mode de réalisation ;
[Fig 7] la figure 7 est un schéma-bloc fonctionnel d'un dispositif de mesure de grandeurs électriques selon un mode de réalisation ;
[Fig 8] la figure 8 est une vue en perspective d'un module de mesure de courant intégré dans le dispositif de mesure de grandeurs électriques représenté dans les figures 5 et 6, selon un mode de réalisation ;
[Fig 9] la figure 9 est un schéma-bloc fonctionnel d'un module d'alimentation électrique intégré dans le dispositif de mesure de grandeurs électriques représenté dans les figures 5 et 6, selon un mode de réalisation ;
[Fig 10] la figure 10 est un exemple de circuits de réalisation du module d'alimentation de la figure 9.

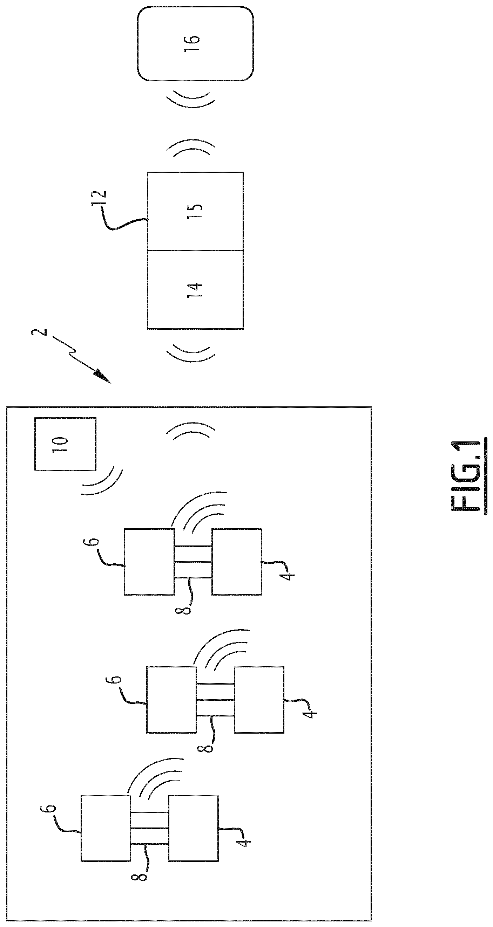

La figure 1 illustre schématiquement un système 2 de calcul de grandeurs électriques distribué dans une installation électrique.

L'installation électrique, qui n'est pas représentée dans la figure 1, est par exemple une installation domestique de distribution d'électricité ou une installation de distribution d'électricité de bâtiment commercial ou administratif, configurée pour fournir une énergie électrique et des charges consommatrices d'énergie électriques, connectées au moyen de conducteurs électriques, à partir d'une ou plusieurs sources d'énergie électrique, comprenant notamment un réseau public de distribution d'électricité, et, optionnellement, des sources locales e.g. des panneaux photovoltaïques.

Les conducteurs électriques sont par exemple des câbles ou barres conductrices en matériau électriquement conducteur.

L'installation électrique peut être une installation monophasée ou polyphasée, comportant un nombre N de phases de courant électrique, avec ou sans conducteur de neutre.

Dans le cas monophasé, des adaptations supplémentaires, par exemple un raccordement à un potentiel de référence, sont introduites.

Dans la représentation schématique de la figure 1, le système 2 de calcul de grandeurs électriques comporte une pluralité de dispositifs 4 de mesure de grandeurs électriques. Chaque dispositif 4 de mesure de grandeurs électriques est connecté, dans l'exemple illustré, à un appareil de protection électrique 6, par exemple un disjoncteur.

Par exemple, dans un mode de réalisation, l'ensemble des disjoncteurs 6 et des dispositifs 4 de mesure de grandeurs électriques est placé dans un tableau électrique ou dans une armoire électrique.

Les dispositifs 4 de mesure de grandeurs électriques seront décrits plus en détail ci-après.

En particulier, chaque dispositif 4 est muni d'une interface de communication sans fil. En d'autres termes, chaque dispositif 4 est un dispositif communicant, muni d'une capacité de communication, selon un protocole sans fil choisi, avec les autres dispositifs communicants du système 2 de calcul de grandeurs électriques.

Par exemple, le protocole de communication sans fil mis en œuvre est le protocole Bluetooth^{®}, ou le protocole Zigbee Green Power.

Comme décrit plus en détail par la suite, chaque dispositif 4 est configuré pour réaliser des mesures de grandeurs électriques caractérisant le signal électrique qui circule dans le ou dans chaque conducteur électrique 8 lorsque de l'installation électrique à surveiller. En particulier, chaque dispositif 4 est configuré pour fournir des mesures de courant électrique en continu sur le ou sur chacun des conducteurs électriques 8 auquel il est connecté, et est configuré pour réaliser en continu une mesure de tension par couplage capacitif.

En plus, chaque dispositif 4 comporte un circuit électronique programmable, e.g. un microprocesseur, configuré pour réaliser de calcul de grandeurs électriques choisies.

Le système 2 comporte en outre, dans un mode de réalisation, un seul dispositif 10 de mesure de tension par contact, muni d'une interface de communication, de manière à permettre la diffusion (en anglais « broadcast ») des mesures de tension réalisées en continu aux dispositifs 4 de mesure de grandeurs électriques, ce qui permet d'améliorer la précision des mesures de tension dans le système.

Le système 2 comprend en outre un dispositif de communication passerelle 12, comportant une première interface de communication 14 configurée pour communiquer selon le protocole de communication sans fil utilisé par les dispositifs 4 mesure de grandeurs électriques, de manière à réaliser une communication bidirectionnelle avec ces dispositifs 4.

En outre, le dispositif de communication passerelle 12 comporte une deuxième interface de communication 15, configurée pour communiquer, par exemple selon un autre protocole de communication, par exemple un protocole de communication sans fil, avec un ou plusieurs dispositifs utilisateur 16.

Par exemple le deuxième protocole de communication est de type sans fil (Bluetooth, ZigBee, WiFi), ou filaire, e.g. Câble Ethernet.

Ainsi, un utilisateur, par exemple un opérateur de maintenance, est capable de recevoir, via le dispositif utilisateur 16, des mesures de grandeurs électriques obtenues, permettant la supervision, la surveillance de bon fonctionnement, la planification de la maintenance prédictive de l'installation électrique concernée.

Les mesures fournies sont par exemple affichées sur une interface homme-machine du dispositif utilisateur 16.

Avantageusement, les dispositifs 4 de mesure de grandeurs électriques sont des dispositifs autonomes en alimentation électrique, donc il n'est pas nécessaire de les connecter de manière filaire, par un câble ou plus généralement par un conducteur électrique, à une source d'alimentation.

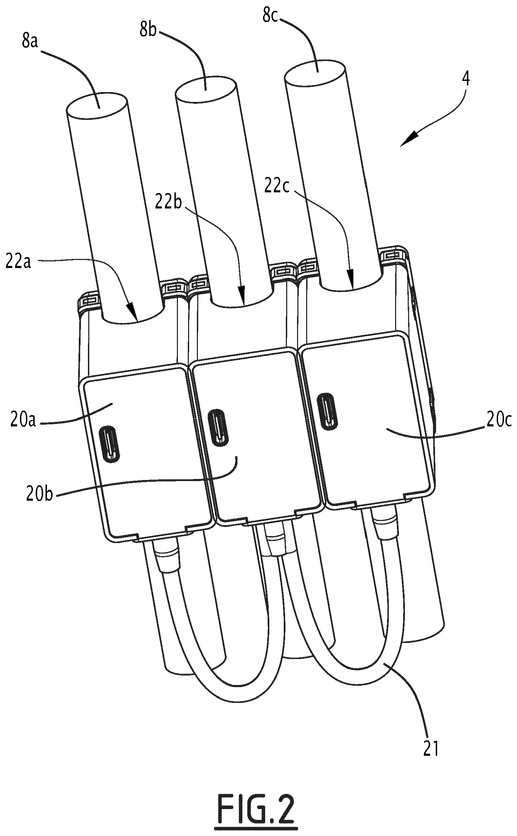

La figure 2 illustre un dispositif 4 de mesure de grandeurs électriques.

Dans l'exemple de la figure 2, le dispositif 4 est intégré dans un boîtier comprenant trois blocs unitaires 20a, 20b, 20c. Ce dispositif 4 est adapté pour une installation électrique triphasée, chaque bloc unitaire étant configuré pour recevoir un conducteur électrique respectif 8a, 8b, 8c, dans un logement traversant 22a, 22b, 22c prévu à cet effet, le conducteur électrique associé étant un conducteur d'une des phases d'un courant électrique triphasé.

Comme illustré dans la figure 2, les blocs unitaires 20a, 20b, 20c respectifs sont agencés côte à côte, et par exemple solidarisés latéralement.

De plus, une connexion électrique série est réalisée entre les blocs unitaires respectifs 20a, 20b, 20c, au moyen d'un conducteur électrique 21.

Dans la suite de la description, un dispositif 4 de mesure de grandeurs électriques intégré dans un boîtier comportant un bloc unitaire 20, et configuré pour la mesure de courant et de tension à partir d'un conducteur de phase, sera décrit.

Les modes de réalisation décrits s'appliquent de manière analogue pour un dispositif 4 comportant une pluralité de blocs unitaires similaires.

Dans un mode de réalisation particulièrement avantageux, le ou chaque bloc unitaire 20 est de type ouvrant, et par conséquent le dispositif 4 est ouvrant.

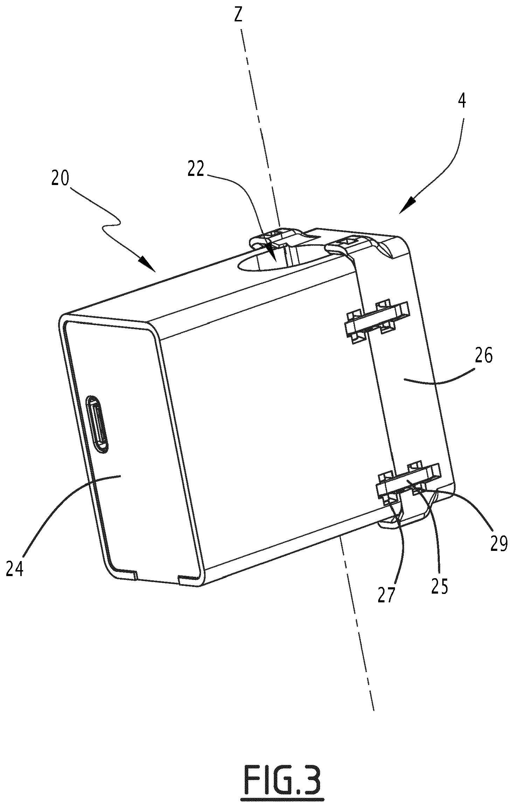

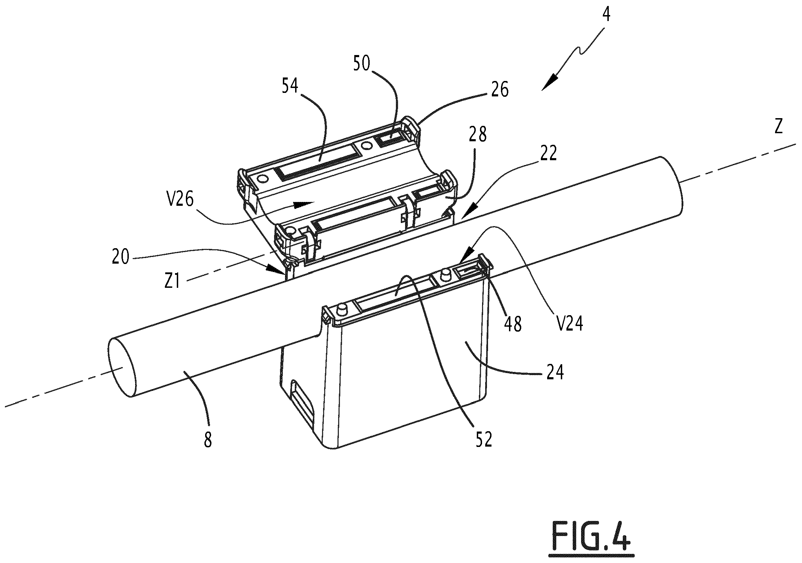

Ainsi, dans ce mode de réalisation, avantageusement, le bloc unitaire 20 est agencé en une première portion 24 et une deuxième portion 26, qui coopèrent pour être assemblées et former un bloc unitaire 20, représenté en position fermée dans la figure 3 et qui sont au moins partiellement séparables comme illustré dans la figure 4.

Dans l'exemple de la figure 3, les première portion 24 et deuxième portion 26 sont solidarisées par des éléments mécaniques de fermeture (ou de « clipsage »).

Un premier volume intérieur V24 est défini à l'intérieur de la première portion 24 du bloc unitaire 20, et un deuxième volume intérieur V26 est défini à l'intérieur de la deuxième portion 26.

Le logement traversant 22 destiné à recevoir le conducteur électrique 8 associé s'étend selon un axe principal Z, dont le sens est appelé sens longitudinal par la suite.

Par exemple, dans le mode de réalisation de la figure 4, le bloc unitaire 20 présente une forme sensiblement parallélépipédique, en d'autres termes la section transversale, dans un plan orthogonal à l'axe principal Z, est sensiblement rectangulaire.

Bien entendu, il s'agit d'un exemple de forme géométrique, mais d'autres formes géométriques sont envisageables.

Dans un mode de réalisation, tel qu'illustré dans la figure 3, la première portion 24 et la deuxième portion 26 sont solidarisées par un système de pivot 25 à deux axes de rotation 27, 29.

Dans un mode de réalisation alternatif, la première portion 24 et la deuxième portion 26 sont liées par une charnière 28, de manière à ce que la deuxième portion 26 soit déplaçable autour d'un axe de rotation Z1, parallèle à l'axe principal Z, et être rabattue sur la première portion 24 pour réaliser l'assemblage en un bloc. La charnière est formée sur une face latérale bloc unitaire 20.

Les première et deuxième portions 24, 26 coopèrent pour former le logement traversant 22, comme illustré dans la figure 4.

Par exemple, si le logement traversant 22 est de forme sensiblement tubulaire, par exemple de section circulaire ou rectangulaire à angles arrondis dans un plan orthogonal à l'axe principal Z, la première portion 24 comporte une partie creuse formant un premier demi-tube dans le sens longitudinal, et la deuxième portion 26 comporte une partie creuse formant un deuxième demi-tube dans le sens longitudinal. Les premier et deuxième demi-tubes réunis forment le logement traversant 22 lorsque la première portion 24 et la deuxième portion 26 sont en position fermée, telle qu'illustrée en figure 3.

Ainsi, avantageusement, dans ce mode de réalisation, le dispositif 4 de mesure de grandeurs physiques est ouvrant, le bloc unitaire 20 étant ouvrant, ce qui permet d'entourer le conducteur électrique 8 sur lequel le dispositif 4 est placé pour prélever des mesures.

Dans un mode de réalisation dans lequel le dispositif 4 comporte plusieurs blocs unitaires 20, les blocs unitaires sont de même forme et de même dimension et sont adaptés pour être ouverts, puis fermés, de manière solidaire.

Avantageusement, cela permet une installation facile du dispositif 4 de mesure de grandeurs physiques sur un conducteur électrique déjà connecté dans une installation électrique sans avoir à déconnecter (ou débrancher) ce conducteur de l'installation électrique.

Selon une variante, la première portion 24 et la deuxième portion 26 sont complétement séparables en translation, et sont configurées pour être réunies par clipsage.

Selon une autre variante, l'une des portions est mobile par rapport à l'autre, et est configurée pour se glisser dans une glissière.

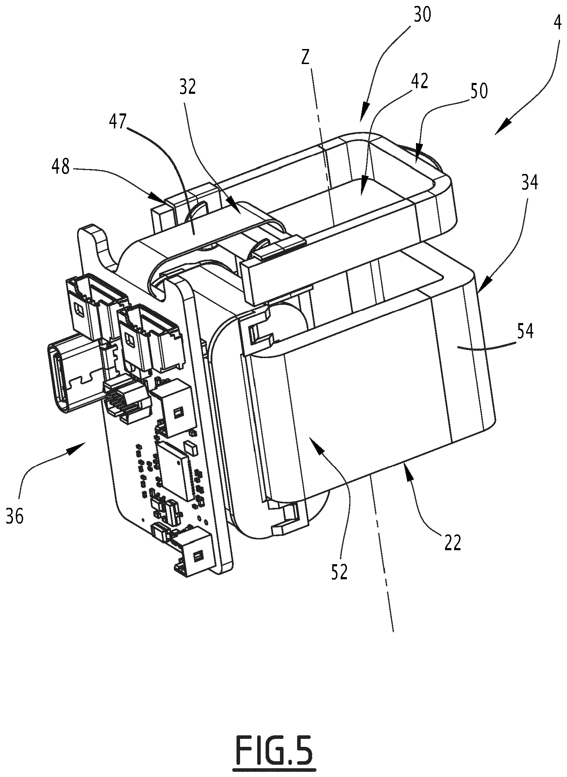

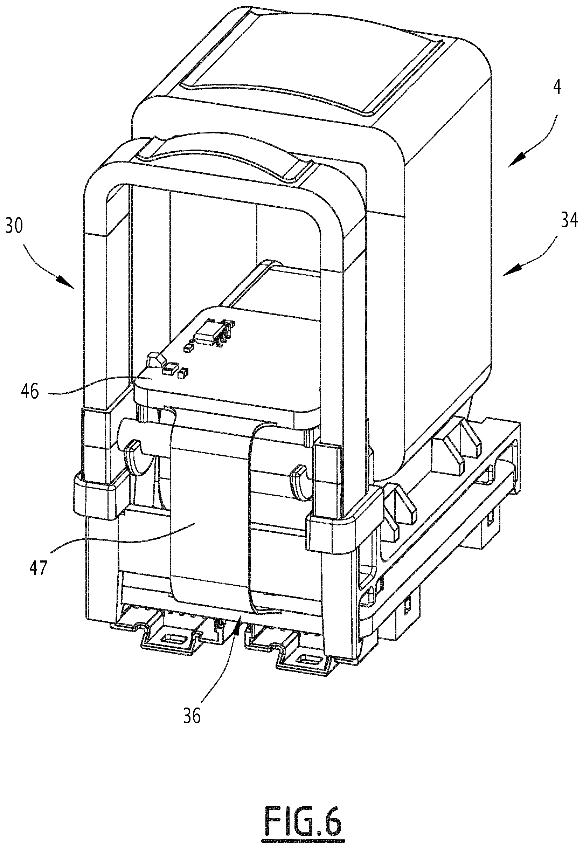

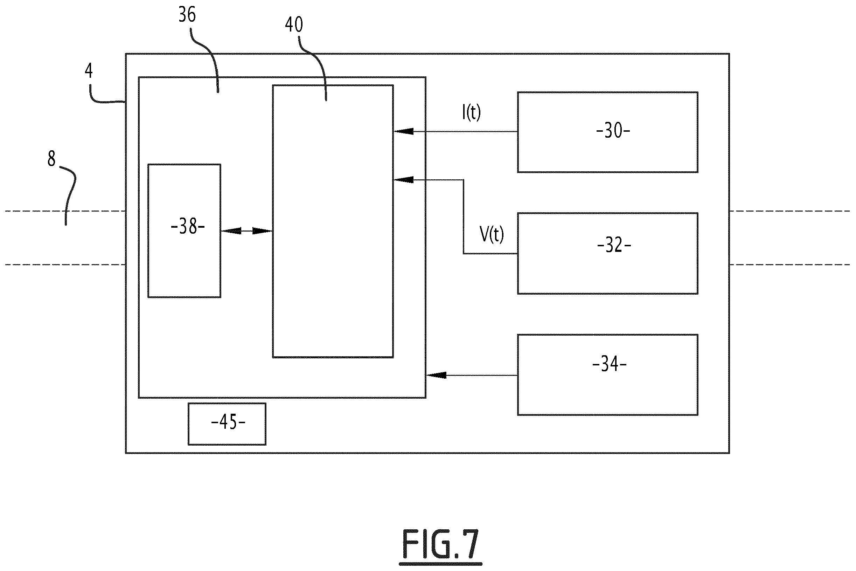

Comme illustré plus en détail dans les figures 5 et 6, selon deux orientations spatiales différentes, et fonctionnellement dans la figure 7, le dispositif 4 de mesure de grandeurs physiques comporte :
- un module 30 de mesure de courant, configuré pour mesurer un courant électrique circulant dans le conducteur électrique qui est inséré dans le logement traversant 22,
- un module 32 de mesure de tension par couplage capacitif,
- un module 34 d'alimentation électrique, configuré pour capter une énergie électrique à partir du courant électrique circulant dans le conducteur électrique qui est inséré dans le logement traversant 22.

Il est à noter que dans les figures 5 et 6 les composants du dispositif 4 de mesure de grandeurs électriques sont représentés en perspective, et les parois du boîtier du bloc unitaire 20 correspondant ne sont pas représentées.

Le dispositif 4 de mesure de grandeurs physiques comporte un dispositif électronique 36, par exemple une carte électronique de type circuit imprimé, comportant une interface de communication 38 et circuit électronique programmable 40.

Le circuit électronique programmable 40 est par exemple un processeur, tel qu'un microprocesseur ou un microcontrôleur programmable.

En variante, le circuit électronique programmable 40 comporte d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

L'interface de communication 38 est une interface de communication sans fil adaptée à communiquer selon un protocole de communication sans fil prédéterminé, par exemple Bluetooth, Zigbee ou Zigbee Green Power.

Le circuit électronique programmable 40 est configuré pour recevoir, de manière continue, des mesures de courant et de tension des modules de mesure de courant 30 et de tension 32, et pour commander la transmission par l'interface de communication 38 d'au moins une grandeur électrique associée au signal électrique circulant dans le conducteur électrique reçu dans le logement traversant 22.

La grandeur électrique est par exemple le courant électrique et/ou la tension.

En outre, dans des modes de réalisation, le circuit électronique programmable 40 est configuré pour exécuter des calculs permettant d'obtenir d'autres grandeurs électriques du signal électrique, obtenues à partir desdites mesures de courant et de tension, comme par exemple une puissance active ou réactive, une énergie électrique, une fréquence, un facteur de puissance, une distorsion harmonique du signal électrique.

Le circuit électronique programmable 40 peut également comporter des composants permettant de mettre en forme et/ou de filtrer les mesures obtenues.

En outre, le dispositif électronique 36 comporte une horloge propre, par exemple un oscillateur électronique, par exemple un oscillateur à cristal, tel qu'un oscillateur à quartz. Par exemple, l'horloge peut être intégrée au microprocesseur 40.

Avantageusement, le module 34 d'alimentation électrique est adapté pour alimenter en électricité le dispositif électronique 36. En d'autres termes, le dispositif 4 de mesure de grandeurs électriques est auto-alimenté.

Le module 30 de mesure de courant, le module 32 de mesure de tension par couplage capacitif, et le module 34 d'alimentation électrique sont agencés dans le bloc unitaire 20 de manière à entourer, en tout ou partie, le conducteur électrique 8, lorsqu'un conducteur électrique est inséré dans le logement traversant 22.

En d'autres termes, les modules 30, 32 et 34 sont agencés autour du logement traversant 22 destiné à recevoir le conducteur électrique 8.

Dans le mode de réalisation des figures 5 et 6, les modules 30 de mesure du courant électrique et 34 d'alimentation électrique sont empilés l'un sur l'autre dans le sens défini par l'axe principal Z, le logement traversant 22 étant formé dans cet empilement.

Le module 30 de mesure de courant comporte une première partie creuse 42, et le module 34 d'alimentation électrique comporte une deuxième partie creuse 44, les parties creuses respectives étant centrées autour de l'axe principal Z et formant le logement traversant 22.

Comme visible dans la figure 6, dans un mode de réalisation le module 32 comporte un support 47, permettant de connecter un capteur de tension 46 et la carte électronique 36, ce qui permet la réalisation de traitements électroniques dans la carte électronique 36.

Le support 47 est en matériau conducteur (flexible ou rigide). Le capteur 46 est dans ce mode de réalisation réalisé sous forme de circuit imprimé, positionné au plus proche du conducteur électrique 8, positionné de manière à s'étendre le long d'un côté du logement traversant 22, comme illustré en figure 6, par exemple à une distance comprise entre 0 et 10 millimètres (mm) du conducteur 8. L'ensemble formé par le capteur 46 et le support conducteur 47, et des traitements électroniques intégrés dans la carte électronique 36 forme un module de mesure de tension par couplage capacitif.

Dans un autre mode de réalisation, le capteur 46 est une pièce métallique agencée sous forme de demi-tube ayant un axe longitudinal s'étendant parallèlement à l'axe principal Z. Ce demi-tube forme une partie creuse, orientée vers le logement traversant 22, connectée via un conducteur non représenté à la carte électronique 36. Ainsi, une mesure de tension sans contact est réalisée. Le support 47 permet de relier le capteur 46 au dispositif électronique 36.

Avantageusement, le module 32 est réalisé dans la première portion 24 du bloc unitaire 20.

Avantageusement, l'agencement proposé des modules respectifs permet de réaliser un dispositif 4 de mesure de grandeurs électriques particulièrement compact.

Dans le mode de réalisation décrit en référence à la figure 4, dans lequel le dispositif 4 de mesure de grandeurs électriques est ouvrant, chacun des modules 30 de mesure de courant et 34 d'alimentation électrique sont de type ouvrant, c'est-à-dire conçus en deux parties au moins partiellement séparables.

Ainsi, le module 30 de mesure de courant comporte une première partie 48 et une deuxième partie 50, au moins partiellement séparables, la première partie 48 du module 30 étant logée dans la première portion 24 du bloc unitaire 20, la deuxième partie 50 du module 30 étant logée dans la deuxième portion 26 du bloc unitaire 20.

De même, dans le mode de réalisation de la figure 4, le module 34 d'alimentation électrique comporte une première partie 52 et une deuxième partie 54, au moins partiellement séparables, la première partie 52 du module 34 étant logée dans la première portion 24 du bloc unitaire 20, la deuxième partie 54 du module 30 étant logée dans la deuxième portion 26 du bloc unitaire 20.

La figure 7 illustre sous forme de circuit fonctionnel le dispositif 2 de mesure de grandeurs électriques.

Outre les éléments décrits ci-dessus, le dispositif 4 de mesure de grandeurs électrique comprend optionnellement un port d'interface de connexion 45 d'un bus informatique en série ou bus USB (pour « universal serial bus »), permettant de connecter un dispositif externe. Avantageusement, cela permet une alimentation électrique du dispositif 4 via un tel dispositif externe, lorsque le conducteur électrique 8 n'est pas traversé par un courant électrique. Par exemple, l'alimentation électrique externe est utile pour permettre une initialisation de l'interface de communication 38 lors de l'installation du dispositif 4 par un opérateur. La liaison série peut aussi être utilisée pour se connecter au circuit programmable/microprocesseur/microcontrôleur pour debugger le système ou mettre à jour le micrologiciel (en anglais « firmware »).

Des modes de réalisation des modules de mesure de courant 30 et d'alimentation électrique 34 sont décrits ci-après en référence aux figures 7 à 9.

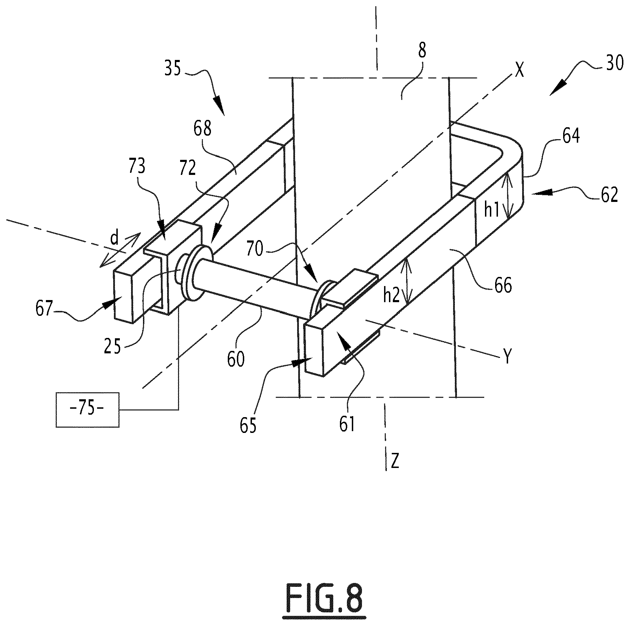

Dans un mode de réalisation préféré, en référence à la figure 8, le module 30 de mesure de courant comprend capteur de courant inductif 35 comportant un enroulement principal 60, également appelé bobinage principal 60, de forme linéaire, et un élément ferromagnétique 62 de forme incurvée, formant ainsi un capteur dit de Rogowski hybride.

Le bobinage ou enroulement principal 60 est formé par exemple par un fil conducteur, e.g. un fil de cuivre, enroulé autour d'un support. Le support est par exemple linéaire, de section circulaire.

En variante, le bobinage principal a une forme incurvée, il est par exemple formé par enroulement d'un fil conducteur autour d'un support torique.

Le support est par exemple en matériau plastique, par exemple en polymère à cristaux liquides (ou LCP).

L'élément ferromagnétique a une forme de « C » inversé, comportant une portion arrondie centrale 64, ayant un axe de symétrie X, et deux bras, respectivement un premier 66 et un deuxième bras 68 s'étendant linéairement de manière symétrique, parallèlement à l'axe de symétrie X de la portion centrale arrondie.

Ainsi, de préférence, l'élément ferromagnétique a une forme géométrique symétrique par rapport à l'axe de symétrie X.

Dans un mode de réalisation, la portion arrondie centrale 64 a une forme rectangulaire à coins arrondis, dans un plan dit transversal (plan X, Y dans la figure 8).

Avantageusement, une telle forme permet une meilleure compatibilité avec un boîtier de type parallélépipédique à coins arrondis.

Néanmoins, d'autres formes à symétrie autour de l'axe de symétrie X sont envisageables, par exemple la portion arrondie centrale 64 a une forme d'arc de cercle.

De préférence, les deux bras 66, 68 sont de mêmes dimensions, e.g. de même longueur, épaisseur, hauteur.

Le bobinage principal 60 est disposé selon un axe Y, orthogonal à l'axe de symétrie X, à proximité spatiale des extrémités 65, 67 des bras 66, 68.

Par exemple, le bobinage principal 60 est disposé à une distance d, selon la direction de l'axe de symétrie X, comprise entre des extrémités 65, 67 des bras 66, 68. Par exemple, la distance d est supérieure ou égale à 1 mm, et de préférence supérieure ou égale à 2 mm.

L'élément ferromagnétique est par exemple réalisé en acier, e.g. un alliage fer-nickel ou fer-silicium.

Le module 30 comporte en outre, optionnellement, des enroulements de compensation 70, 72, disposés entre chaque extrémité 61, 63 du bobinage principal 60 et les bras 66, 68 de l'élément ferromagnétique 62, de manière à compenser en partie le jeu entre le fil conducteur et les bras 66,68 de l'élément ferromagnétique, et à améliorer les performances électromagnétiques.

Dans un mode de réalisation, le bobinage principal 60 est fixé aux bras respectifs 66, 68 au moyen de pièces de fixation 73, qui sont par exemple en matériau thermorésistant, par exemple en plastique de type polymère cristaux-liquides (ou LCP).

Les enroulements de compensation 70, 72 sont de préférence symétriques.

Le capteur de courant 35 de type Rogowski hybride ainsi réalisé est symétrique selon une symétrie axiale par rapport à l'axe X.

Le module 30 comprend en outre un circuit de traitement 75, par exemple un circuit électrique ou électronique, connecté au fil conducteur.

Dans un mode de réalisation le circuit traitement est intégré dans le circuit électronique programmable 40. Par exemple, le circuit de traitement comporte notamment un filtre anti-repliement, un bloc de conversion numérique-analogique, un bloc d'intégration temporelle du signal électrique pour obtenir une mesure de courant I(t), et un bloc de calcul de grandeurs électriques, par exemple des valeurs moyenne ou moyenne quadratique du courant électrique.

Le dimensionnement de l'élément ferromagnétique 62 est choisi de manière compatible avec les dimensions du bloc unitaire 20.

Le volume intérieur de l'élément ferromagnétique en forme de C inversé forme une partie du logement traversant 20.

De préférence, le capteur de courant 35 est ouvrant, et ainsi compatible avec un dispositif 4 de mesure de grandeurs électriques ouvrant.

Dans un mode de réalisation, l'élément ferromagnétique est séparable, par exemple la portion arrondie centrale 64 est séparable des bras respectifs 66, 68, le bobinage principal 60, avec ou sans enroulements de compensation 70, 72, est étant fixé respectivement aux bras 66 et 68. Par exemple, les bras 66, 68 sont fixés sur le support du bobinage principal par bouterollage.

Dans un mode de réalisation, la portion centrale arrondie 64 a une hauteur h1 et chacun des bras 66, 68 a une hauteur h2, h2 étant inférieure à h1. Avantageusement, cela permet de garantir un flux minimum circulant dans le capteur, en garantissant une surface minimale d'échange du flux, et une robustesse aux jeux mécaniques entre les pièces.

En variante, les hauteurs h1 et h2 sont égales.

Dans un mode de réalisation, la portion centrale arrondie 64 et les bras 66, 68 ont une épaisseur de matériau ferromagnétique, de préférence comprise entre 1 et 5mm.

Avantageusement, le capteur de courant 35 est un capteur à fort gain, de l'ordre de 250 µV/Amp à 50 Hz.

Ainsi, dans un mode de réalisation, la portion arrondie 64 forme la deuxième partie 50 du module 30 représentée dans la figure 5, et l'ensemble formé par les bras 66, 68, le bobinage principal 60 et les enroulements de compensation 70, 72 forment la première partie 48 du module 30.

Il est avantageux de former la séparation en deux parties dans l'élément ferromagnétique car l'élément ferromagnétique est robuste vis-à-vis de manipulations répétées d'ouverture et fermeture.

En variantes, d'autres agencements de la séparation en deux parties sont envisageables.

En variante, tout autre type de capteur de Rogowski ouvrant peut être utilisé, ainsi qu'un transformateur de courant ou un capteur à effet hall.

Le capteur de courant 35 est connecté à un circuit de traitement, électrique ou électronique 75, qui permet notamment de réaliser une intégration pour obtenir la mesure de courant électrique.

Dans un mode de réalisation préféré, le circuit de traitement 35 est intégré dans le microprocesseur 40 du dispositif 4.

Avantageusement, le capteur de courant 35 proposé est particulièrement compact et robuste, et permet une bonne précision de mesure de courant électrique.

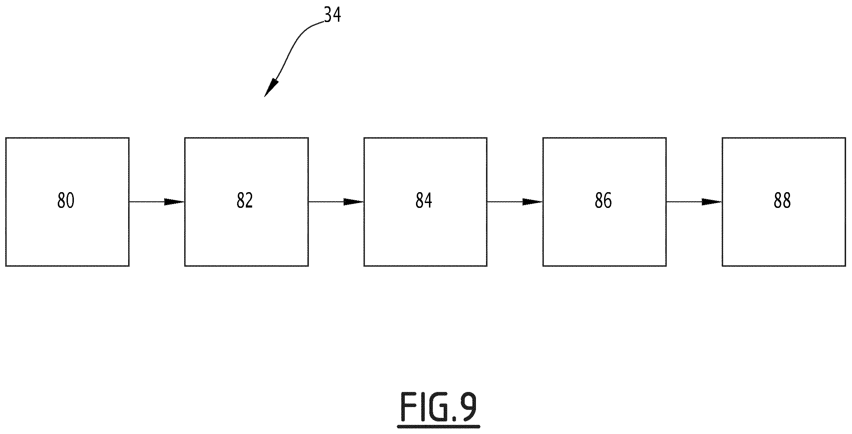

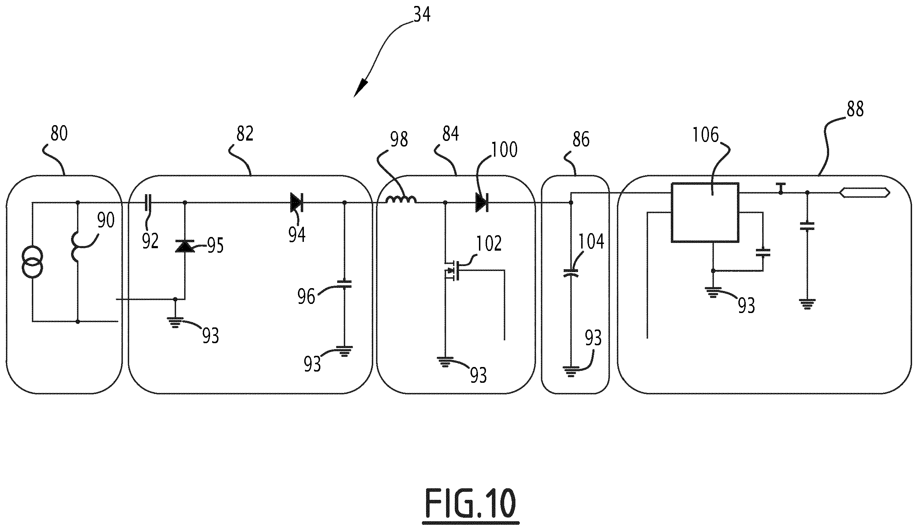

Un mode de réalisation d'un module d'alimentation électrique 34 est décrit en référence aux figures 9 et 10.

Le module d'alimentation électrique 34 est configuré pour collecter de l'énergie électrique à partir du champ magnétique créé lorsque le conducteur électrique 8, inséré dans le logement 22 du dispositif 4 de mesure de grandeurs électriques est traversé par un courant électrique, et pour fournir cette énergie électrique pour l'alimentation du dispositif électronique 36 intégré dans le dispositif 4 de mesure de grandeurs électriques.

Ainsi, le module d'alimentation électrique 34 est configuré pour convertir une énergie électrique alternative en énergie continue pour alimenter une charge qui est le dispositif électronique 36.

Avantageusement, le dispositif 4 de mesure de grandeurs électriques est alors auto-alimenté et sans fil, tout en fournissant en continu des mesures de courant et de tension.

A cet effet, le module d'alimentation électrique 34 comporte un bloc de transformation de courant 80 comportant un transformateur de courant, un bloc 82 de conversion alternatif/continu ou AC/DC avec un circuit résonant (ou non résonant) connecté en sortie du bloc de transformation de courant.

Avantageusement, dans un mode de réalisation, le bloc 82 de conversion AC/DC est un doubleur de tension, par exemple un circuit multiplicateur de tension de Greinacher.

Optionnellement, en sortie du bloc 82 de conversion AC/DC est connecté un bloc d'adaptation d'impédance 84, dont la sortie est connectée en entrée d'un bloc de stockage d'énergie électrique 86. Le bloc d'adaptation d'impédance 84 est optionnel.

Le module 34 comporte en outre un bloc 88 de régulation de tension, adapté pour réguler la tension continue en sortie du module d'alimentation électrique 34 aux besoin de la charge.

Un exemple de circuits électriques permettant de réaliser chacun des blocs décrits fonctionnellement ci-dessus en référence à la figure 9 est illustré dans la figure 10.

Le bloc de transformation de courant 80 comportant un transformateur de courant. de type transformateur magnétique de courant, comporte des enroulements (ou bobines électriques) primaire et secondaire, les courants électriques traversant ces enroulements étant respectivement appelés courant primaire et courant secondaire. Le courant secondaire est pratiquement proportionnel au courant primaire et déphasé de celui-ci d'un angle voisin de zéro pour un sens approprié des connexions.

Dans la figure 10 est représenté un modèle électrique équivalent d'un tel transformateur magnétique de courant, comportant une source de courant et un composant inductif 90, appelé composant inductif équivalent, en parallèle de la source de courant, dont l'inductance L1 est appelée inductance magnétisante équivalente du transformateur magnétique de courant 80.

Le bloc 82 de conversion AC/DC comporte un condensateur dit de compensation 92 et une diode anti-retour 94 connectée en sortie du condensateur de compensation 92.

De plus, le bloc 82 comporte une autre diode 95, connectée entre un point 91, qui est un nœud entre la sortie du condensateur 92 et l'entrée de la diode anti-retour 94 et un point 93 de potentiel bas, par exemple connecté à la masse.

De préférence, le condensateur de compensation 92 a une capacité choisie en fonction de l'inductance magnétisante équivalente du transformateur de courant, de manière à obtenir une résonance et compenser une perte d'énergie due transformateur de courant.

Dans un mode de réalisation la capacité C1 du condensateur de compensation 92 est calculée en fonction de l'inductance magnétisante équivalente L1 par la formule suivante : [MATH 1] ${C}_{1} = \frac{1}{{L}_{1} \times {ω}_{0}^{2}}$

Où *ω*₀ est la pulsation du courant électrique alternatif en sortie du bloc de transformation de courant 80, où *ω*₀ *= 2πf*₀, f₀ étant la fréquence du signal électrique.

Lorsque la capacité C1 du condensateur de compensation 92 est calculée par la formule [MATH 1], le bloc 82 de conversion AC/DC est dit résonant avec le bloc de transformation de courant 80. De plus, le bloc de conversion AC/DC comporte en outre un autre condensateur 96, connecté entre la masse et la sortie de la diode anti-retour 94.

Le bloc d'adaptation d'impédance 84, dans un mode de réalisation, comporte une inductance 98 connectée en sortie du bloc 82, une diode 100 connectée en sortie de l'inductance 98 et un transistor 102, connecté entre un nœud 95 situé entre la sortie de l'inductance 98 et l'entrée de la diode 100, commandé par un signal de commande en fonction de la tension fournie en sortie du module 34. Le transistor 102 a une fonction d'interrupteur.

Le transistor 102 est par exemple un transistor à effet de champ de type MOSFET à canal N.

Le bloc de stockage d'énergie 86 comporte un condensateur de stockage 104 connecté entre la sortie du bloc d'adaptation d'impédance et la masse.

Le bloc de régulation comporte un régulateur 106 et, optionnellement, des condensateurs supplémentaires pour la régulation d'énergie.

Des variantes de mise en œuvre des divers blocs 80, 82, 84, 86 et 88 par des circuits électriques sont applicables.

Avantageusement, dans un mode de réalisation, le bloc de transformation de courant 80 est réalisé sous forme de bobinages associés à un élément ferromagnétique, et le bloc de conversion AC/DC 82, le bloc optionnel d'adaptation d'impédance 84, le bloc de stockage d'énergie électrique 86 et le bloc 88 de régulation de tension sont intégrés dans le circuit électronique programmable 40 (e.g. le microprocesseur) du dispositif 4.

Par exemple, dans un mode de réalisation, une partie du transformateur magnétique de courant du bloc de transformation de courant 80 est intégré dans la première partie 52 et la deuxième partie 54 du module 34 est formée d'un élément ferromagnétique du transformateur magnétique de courant du bloc de transformation de courant 80. De préférence, les première et deuxième parties sont au moins partiellement séparables, le module d'alimentation électrique 34 étant alors ouvrant.

Avantageusement, l'utilisation d'un doubleur de tension de type Greinacher permet de compenser les pertes induites par l'inductance magnétisante équivalente du bloc de transformation de courant.

Avantageusement, l'ajout en outre d'un bloc d'adaptation d'impédance permet d'optimiser la fourniture d'énergie électrique par le module d'alimentation électrique 34, tout en permettant de réduire l'encombrement de ce module.

Cela permet alors l'intégration facile dans un bloc unitaire 20, par exemple de dimensions inférieures à 50 mm par dimension, par exemple de l'ordre de 40x45x26 mm.

Ainsi, l'invention permet de réaliser un dispositif de mesure de grandeurs électriques particulièrement compact, communicant et autonome en alimentation électrique.

## Revendications

1. Dispositif de mesure de grandeurs électriques dans une installation électrique, intégré dans un boîtier comprenant au moins un bloc unitaire (20), le bloc unitaire comportant un logement traversant (22) adapté pour recevoir un conducteur électrique (8) de ladite installation électrique, le logement traversant (22) s'étendant selon un axe principal (Z), le ou chaque bloc unitaire (20) comprenant :
- un module (30) de mesure de courant, configuré pour mesurer un courant électrique circulant dans ledit conducteur électrique,
- un module (32) de mesure de tension par couplage capacitif,
- un module (34) d'alimentation électrique, configuré pour capter une énergie électrique à partir dudit conducteur électrique,
lesdits modules étant agencés autour dudit logement traversant (22, 22a, 22b, 22c) destiné à recevoir le conducteur électrique (8, 8a, 8b, 8c),
**caractérisé en ce que** :
le module (30) de mesure de courant et le module (34) d'alimentation électrique sont empilés dans le sens défini par l'axe principal (Z), le module (30) de mesure de courant comporte une première partie creuse (42) et le module (34) d'alimentation électrique comporte une deuxième partie creuse (44), lesdites première et deuxième parties creuses étant centrées autour de l'axe principal (Z) et formant le logement traversant (22),
le bloc unitaire (20) comportant en outre dispositif électronique (36), comportant une interface de communication sans fil (38) adaptée à communiquer selon un protocole de communication sans fil prédéterminé et un circuit électronique programmable (40),
le dispositif électronique (36) étant alimenté en énergie électrique par ledit module d'alimentation électrique (34), le circuit électronique programmable (40) étant configuré pour recevoir, de manière continue, des mesures de courant et de tension desdits modules (30, 32) de mesure de courant et de tension, et pour commander la transmission par ladite interface de communication (38) d'au moins une grandeur électrique associée au signal électrique circulant dans le conducteur électrique (8, 8a, 8b, 8c) reçu dans le logement traversant (22, 22a, 22b, 22c), obtenue à partir desdites mesures de courant et de tension.

2. Dispositif selon la revendication 1, dans lequel ladite grandeur électrique est un courant, une tension, une puissance active ou réactive, une énergie électrique, une fréquence, un facteur de puissance, une distorsion harmonique du signal électrique.

3. Dispositif selon l'une quelconque des revendications 1 ou 2, dans lequel le ou chaque bloc unitaire (20, 20a, 20b, 20c) est agencé en une première portion (24) et une deuxième portion (26) assemblées, lesdites première et deuxième portions (24, 26) étant au moins partiellement séparables l'une de l'autre, de manière à permettre une ouverture et une fermeture dudit bloc unitaire (20, 20a, 20b, 20c), lesdites première et deuxième portions (24, 26) coopérant pour former le logement traversant (22, 22a, 22b, 22c).

4. Dispositif selon la revendication 3, dans lequel lesdites première portion et deuxième portions (24, 26) sont liées par au moins un pivot (25) à deux axes de rotation (27, 29).

5. Dispositif selon l'une des revendications 1 à 4, dans le module de mesure de tension (32) comporte un capteur (46) s'étendant dans le logement traversant (22) selon la direction de l'axe principal (Z) et un support (47) connecté audit capteur (46) et au dispositif électronique (36), formant un capteur de tension par couplage capacitif avec le conducteur électrique.

6. Dispositif selon l'une quelconque des revendications 1 à 5, dans lequel le module (30) de mesure de courant comporte un capteur de courant (35), le capteur de courant (35) comportant un enroulement principal (60) de fil conducteur, et un élément ferromagnétique (62) de forme incurvée, comportant une portion centrale arrondie (64) et deux bras (66, 68) de même longueur s'étendant de part et d'autre de la portion centrale arrondie (64), l'élément ferromagnétique (62) ayant un axe de symétrie parallèle (X) à chacun des bras (66, 68), l'enroulement principal (60) s'étendant selon une direction (Y) perpendiculaire audit axe de symétrie (X), et étant disposé entre lesdits bras (66, 68) de l'élément ferromagnétique (62).

7. Dispositif selon la revendication 6, dans lequel le capteur de courant (35) est configuré pour s'ouvrir en deux parties, une première partie (48) comportant au moins l'enroulement principal (60) et lesdits bras, et une deuxième partie (50) comportant la portion centrale arrondie (64).

8. Dispositif selon la revendication 6 ou 7, dans lequel l'enroulement principal (60) a une première extrémité et une deuxième extrémité, lesdits bras (66, 68) de l'élément ferromagnétique (62) étant respectivement un premier bras et un deuxième bras, le capteur (35) comportant en outre des enroulements de compensation (70, 72), disposés de part et d'autre de l'enroulement principal (60), respectivement entre la première extrémité de l'enroulement principal (60) et le premier bras (66) et entre la deuxième extrémité de l'enroulement principal (60) et le deuxième bras (68).

9. Dispositif selon l'une quelconque des revendications 1 à 8, dans lequel le module d'alimentation électrique (34) comporte un bloc de transformation de courant (80) comportant un transformateur magnétique de courant ayant une inductance magnétisante équivalente, un bloc (82) de conversion alternatif/continu comportant un condensateur dit de compensation (92), configuré pour compenser une perte d'énergie due au transformateur magnétique de courant, et un bloc de stockage d'énergie électrique (86).

10. Dispositif selon la revendication 9, dans lequel le module d'alimentation électrique (34) comporte en outre un bloc d'adaptation d'impédance (84) connecté entre le bloc (82) de conversion et le bloc de stockage d'énergie (86).

11. Dispositif selon l'une des revendications 9 ou 10, dans lequel le bloc (82) de conversion est bloc multiplicateur de tension comportant le condensateur compensation (92) et une diode anti-retour (94) connectée en sortie du condensateur de compensation (92), le condensateur de compensation (92) ayant une capacité choisie pour compenser l'inductance magnétisante équivalente du transformateur magnétique de courant.

12. Système de calcul de grandeurs électriques dans une installation électrique, comportant une pluralité de dispositifs (4) de dispositifs de mesure de grandeurs électriques conformes aux revendications 1 à 11, et un dispositif de communication passerelle (12), configurés pour communiquer selon un protocole de communication sans fil choisi.

## Patentansprüche

1. Vorrichtung zur Messung elektrischer Größen in einer elektrischen Anlage, integriert in ein Gehäuse, das mindestens einen Einheitsblock (20) umfasst, wobei der Einheitsblock eine durchgehende Aufnahme (22) aufweist, die dazu geeignet ist, einen elektrischen Leiter (8) der genannten elektrischen Anlage aufzunehmen, wobei sich die durchgehende Aufnahme (22) gemäß einer Hauptachse (Z) erstreckt, wobei der oder jeder Einheitsblock (20) umfasst:
- ein Modul (30) zur Strommessung, das konfiguriert ist, einen elektrischen Strom zu messen, der in dem genannten elektrischen Leiter fließt,
- ein Modul (32) zur Spannungsmessung durch kapazitive Kopplung,
- ein Modul (34) zur elektrischen Versorgung, das konfiguriert ist, eine elektrische Energie ausgehend von dem genannten elektrischen Leiter aufzunehmen,
wobei die genannten Module um die genannte durchgehende Aufnahme (22, 22a, 22b, 22c) angeordnet sind, die dazu bestimmt ist, den elektrischen Leiter (8, 8a, 8b, 8c) aufzunehmen,
**dadurch gekennzeichnet, dass**:
das Modul (30) zur Strommessung und das Modul (34) zur elektrischen Versorgung in der durch die Hauptachse (Z) definierten Richtung gestapelt sind, das Modul (30) zur Strommessung einen ersten hohlen Teil (42) aufweist und das Modul (34) zur elektrischen Versorgung einen zweiten hohlen Teil (44) aufweist, wobei die genannten ersten und zweiten hohlen Teile um die Hauptachse (Z) zentriert sind und die durchgehende Aufnahme (22) bilden,
wobei der Einheitsblock (20) ferner elektronische Vorrichtung (36) aufweist, aufweisend eine drahtlose Kommunikationsschnittstelle (38), die dazu geeignet ist, gemäß einem vorbestimmten drahtlosen Kommunikationsprotokoll zu kommunizieren, und eine programmierbare elektronische Schaltung (40),
wobei die elektronische Vorrichtung (36) von dem genannten Modul zur elektrischen Versorgung (34) mit elektrischer Energie versorgt wird, wobei die programmierbare elektronische Schaltung (40) konfiguriert ist, kontinuierlich Strom- und Spannungsmessungen der genannten Module (30, 32) zur Strom- und Spannungsmessung zu empfangen, und die Übertragung durch die genannte Kommunikationsschnittstelle (38) mindestens einer elektrischen Größe zu steuern, die dem elektrischen Signal zugeordnet ist, das in dem elektrischen Leiter (8, 8a, 8b, 8c) fließt, der in der durchgehenden Aufnahme (22, 22a, 22b, 22c) aufgenommen ist, erhalten ausgehend von den genannten Strom- und Spannungsmessungen.

2. Vorrichtung nach Anspruch 1, wobei die genannte elektrische Größe ein Strom, eine Spannung, eine Wirkleistung oder Blindleistung, eine elektrische Energie, eine Frequenz, ein Leistungsfaktor, eine harmonische Verzerrung des elektrischen Signals ist.

3. Vorrichtung nach einem der Ansprüche 1 oder 2, wobei der oder jeder Einheitsblock (20, 20a, 20b, 20c) in einem ersten Abschnitt (24) und einem zweiten Abschnitt (26) angeordnet ist, die zusammengefügt sind, wobei die genannten ersten und zweiten Abschnitte (24, 26) mindestens teilweise voneinander trennbar sind, derart, dass ein Öffnen und ein Schließen des genannten Einheitsblocks (20, 20a, 20b, 20c) ermöglicht wird, wobei die genannten ersten und zweiten Abschnitte (24, 26) zusammenwirken, um die durchgehende Aufnahme (22, 22a, 22b, 22c) zu bilden.

4. Vorrichtung nach Anspruch 3, wobei der genannte erste Abschnitt und zweite Abschnitt (24, 26) durch mindestens ein Gelenk (25) mit zwei Drehachsen (27, 29) verbunden sind.

5. Vorrichtung nach einem der Ansprüche 1 bis 4, in dem das Spannungsmessmodul (32) einen Sensor (46) aufweist, der sich in der durchgehenden Aufnahme (22) gemäß der Richtung der Hauptachse (Z) erstreckt, und einen Träger (47), der mit dem genannten Sensor (46) und mit der elektronischen Vorrichtung (36) verbunden ist, und einen Spannungssensor durch kapazitive Kopplung mit dem elektrischen Leiter bildet.

6. Vorrichtung nach einem beliebigen der Ansprüche 1 bis 5, wobei das Modul (30) zur Strommessung einen Stromsensor (35) aufweist, wobei der Stromsensor (35) eine Hauptwicklung (60) aus leitendem Draht und ein ferromagnetisches Element (62) von gekrümmter Form aufweist, aufweisend einen abgerundeten zentralen Abschnitt (64) und zwei Arme (66, 68) gleicher Länge, die sich beiderseits des abgerundeten zentralen Abschnitts (64) erstrecken, wobei das ferromagnetische Element (62) eine Symmetrieachse parallel (X) zu jedem der Arme (66, 68) aufweist, wobei sich die Hauptwicklung (60) gemäß einer Richtung (Y) senkrecht zu der genannten Symmetrieachse (X) erstreckt und zwischen den genannten Armen (66, 68) des ferromagnetischen Elements (62) angeordnet ist.

7. Vorrichtung nach Anspruch 6, wobei der Stromsensor (35) konfiguriert ist, sich in zwei Teile zu öffnen, wobei ein erster Teil (48) mindestens die Hauptwicklung (60) und die genannten Arme aufweist, und ein zweiter Teil (50) den abgerundeten zentralen Abschnitt (64) aufweist.

8. Vorrichtung nach Anspruch 6 oder 7, wobei die Hauptwicklung (60) ein erstes Ende und ein zweites Ende aufweist, wobei die genannten Arme (66, 68) des ferromagnetischen Elements (62) jeweils ein erster Arm und ein zweiter Arm sind, wobei der Sensor (35) ferner Kompensationswicklungen (70, 72) aufweist, die beiderseits der Hauptwicklung (60) angeordnet sind, jeweils zwischen dem ersten Ende der Hauptwicklung (60) und dem ersten Arm (66) und zwischen dem zweiten Ende der Hauptwicklung (60) und dem zweiten Arm (68).

9. Vorrichtung nach einem beliebigen der Ansprüche 1 bis 8, wobei das Modul zur elektrischen Versorgung (34) einen Stromtransformationsblock (80), der einen magnetischen Stromtransformator mit einer äquivalenten Magnetisierungsinduktivität aufweist, einen Wechselstrom/Gleichstrom-Wandlungsblock (82), der einen sogenannten Kompensationskondensator (92) aufweist, der konfiguriert ist, einen Energieverlust aufgrund des magnetischen Stromtransformators zu kompensieren, und einen Speicherblock für elektrische Energie (86) aufweist.

10. Vorrichtung nach Anspruch 9, wobei das Modul zur elektrischen Versorgung (34) ferner einen Impedanzanpassungsblock (84) aufweist, der zwischen den Wandlungsblock (82) und den Energiespeicherblock (86) geschaltet ist.

11. Vorrichtung nach einem der Ansprüche 9 oder 10, wobei der Wandlungsblock (82) ein Spannungsvervielfacherblock ist, der den Kompensationskondensator (92) und eine Rückflussverhinderungsdiode (94) importiert, die am Ausgang des Kompensationskondensators (92) angeschlossen ist, wobei der Kompensationskondensator (92) eine Kapazität aufweist, die gewählt ist, um die äquivalente Magnetisierungsinduktivität des magnetischen Stromtransformators zu kompensieren.

12. System zur Berechnung elektrischer Größen in einer elektrischen Anlage, aufweisend eine Mehrzahl von Vorrichtungen (4) von Vorrichtungen zur Messung elektrischer Größen gemäß den Ansprüchen 1 bis 11, und eine Gateway-Kommunikationsvorrichtung (12), die konfiguriert sind, gemäß einem gewählten drahtlosen Kommunikationsprotokoll zu kommunizieren.

## Claims

1. Device for measuring electrical quantities in an electrical installation, integrated in a casing comprising at least one unit block (20), the unit block comprising a through-recess (22) adapted to receive an electrical conductor (8) of said electrical installation, the through-recess (22) extending along a main axis (Z), the or each unit block (20) comprising:
- a current measurement module (30), configured to measure an electric current flowing in said electrical conductor,
- a voltage measurement module (32) by capacitive coupling,
- an electrical power supply module (34), configured to capture electrical energy from said electrical conductor,
said modules being arranged around said through-recess (22, 22a, 22b, 22c) intended to receive the electrical conductor (8, 8a, 8b, 8c),
**characterized in that**:
the current measurement module (30) and the electrical power supply module (34) are stacked in the direction defined by the main axis (Z), the current measurement module (30) comprises a first hollow part (42) and the electrical power supply module (34) comprises a second hollow part (44), said first and second hollow parts being centered around the main axis (Z) and forming the through-recess (22),
the unit block (20) further comprising electronic device (36), comprising a wireless communication interface (38) adapted to communicate according to a predetermined wireless communication protocol and a programmable electronic circuit (40),
the electronic device (36) being supplied with electrical energy by said electrical power supply module (34), the programmable electronic circuit (40) being configured to receive, continuously, current and voltage measurements from said current and voltage measurement modules (30, 32), and to control the transmission by said communication interface (38) of at least one electrical quantity associated with the electrical signal flowing in the electrical conductor (8, 8a, 8b, 8c) received in the through-recess (22, 22a, 22b, 22c), obtained from said current and voltage measurements.

2. Device according to claim 1, wherein said electrical quantity is a current, a voltage, an active or reactive power, an electrical energy, a frequency, a power factor, or a harmonic distortion of the electrical signal.

3. Device according to any one of claims 1 or 2, wherein the or each unit block (20, 20a, 20b, 20c) is arranged as a first portion (24) and a second portion (26) assembled, said first and second portions (24, 26) being at least partially separable from one another, so as to allow an opening and a closing of said unit block (20, 20a, 20b, 20c), said first and second portions (24, 26) cooperating to form the through-recess (22, 22a, 22b, 22c).

4. Device according to claim 3, wherein said first portion and second portions (24, 26) are linked by at least one pivot (25) with two axes of rotation (27, 29).

5. Device according to one of claims 1 to 4, in the voltage measurement module (32) comprises a sensor (46) extending in the through-recess (22) along the direction of the main axis (Z) and a support (47) connected to said sensor (46) and to the electronic device (36), forming a voltage sensor by capacitive coupling with the electrical conductor.

6. Device according to any one of claims 1 to 5, wherein the current measurement module (30) comprises a current sensor (35), the current sensor (35) comprising a main winding (60) of conductive wire, and a ferromagnetic element (62) of curved shape, comprising a rounded central portion (64) and two arms (66, 68) of the same length extending on either side of the rounded central portion (64), the ferromagnetic element (62) having an axis of symmetry (X) parallel to each of the arms (66, 68), the main winding (60) extending along a direction (Y) perpendicular to said axis of symmetry (X), and being disposed between said arms (66, 68) of the ferromagnetic element (62).

7. Device according to claim 6, wherein the current sensor (35) is configured to open into two parts, a first part (48) comprising at least the main winding (60) and said arms, and a second part (50) comprising the rounded central portion (64).

8. Device according to claim 6 or 7, wherein the main winding (60) has a first end and a second end, said arms (66, 68) of the ferromagnetic element (62) being respectively a first arm and a second arm, the sensor (35) further comprising compensation windings (70, 72), disposed on either side of the main winding (60), respectively between the first end of the main winding (60) and the first arm (66) and between the second end of the main winding (60) and the second arm (68).

9. Device according to any one of claims 1 to 8, wherein the electrical power supply module (34) comprises a current transformation block (80) comprising a magnetic current transformer having an equivalent magnetizing inductance, an AC/DC conversion block (82) comprising a capacitor referred to as compensation capacitor (92), configured to compensate an energy loss due to the magnetic current transformer, and an electrical energy storage block (86).

10. Device according to claim 9, wherein the electrical power supply module (34) further comprises an impedance matching block (84) connected between the conversion block (82) and the energy storage block (86).

11. Device according to one of claims 9 or 10, wherein the conversion block (82) is voltage multiplier block importing the compensation capacitor (92) and an anti-return diode (94) connected at the output of the compensation capacitor (92), the compensation capacitor (92) having a capacitance chosen to compensate the equivalent magnetizing inductance of the magnetic current transformer.

12. System for calculating electrical quantities in an electrical installation, comprising a plurality of devices (4) of devices for measuring electrical quantities compliant with claims 1 to 11, and a gateway communication device (12), configured to communicate according to a chosen wireless communication protocol.
